# EUROPEAN PATENT APPLICATION

(11) **EP 1 852 705 A1**
(43) Date of publication of application: **07.11.2007**
(21) Application number: 05795762.3
(22) Date of filing: 14.10.2005
(51) Int. Cl.: G01R 31/02

(54) **WIRING CONNECTED STATE INSPECTING INSTRUMENT**

(30) Priority: 21.02.2005 WO PCT/JP2005/003235
(71) Applicant: Test Research Laboratories Inc., Omura-shi Nagasaki 856-0022 (JP)
(72) Inventor: TANAKA, Yoshito, Nagasaki-shi, Nagasaki 8510122 (JP)
(74) Representative: Vossius & Partner
(86) International application number: PCT/JP2005/019345
(87) International publication number: WO 2006/087844

(57) **Abstract**

An instrument comprises an odd multiplexer (11o) for sequentially selecting terminals connected to odd wires one by one, an even multiplexer (11e) for sequentially selecting terminals connected to even wires on by one, odd relay switches (13o₋₁, 13o₋₂) for switching connection of the odd multiplexer (11o) to a ground terminal, and even relay switches (11e₋₁), 11e₋₂) for switching connection of the even multiplexer (11e) to a ground terminal. The multiplexers are operated at high speed in such a way that when one of the relay switches does not select connection to the ground terminal, and other selects connection to the ground terminal. By using such multiplexers, wires are sequentially selected at high speed, and the wire adjacent to the selected wire is grounded by the relay switch. While thus switching, the potential appearing at an input terminal (2) of a multiplexer is measured. In this way, an open test and a short test of wiring can be made at high speed.

## Description

### [Field of the Invention]

The present invention relates to a wiring connected state inspecting instrument, and is particularly suitably used for inspecting wiring for an open fault (disconnecting/open-circuit) of a wire and a short fault (short-circuit) between wires at the same time.

### [Background of the Invention]

Generally, in manufacturing a semiconductor integrated circuit, it is necessary to carry out various inspections for rejecting defective products. Among the inspection items, there is a so-called the "open/short test" for inspecting wiring for an open-circuit of a wire and a short-circuit between wires. This open/short test is one of the most time-consuming tests among many inspection items. Therefore, it is desired that an amount of time necessary for this open/short test is reduced as much as possible.

From the viewpoint of such circumstances, conventionally, a method by which an open fault and a short fault can be inspected at the same time has been proposed. (For example, see Patent Documents 1, 2).
[Patent Document 1]: Japanese Patent Laid-Open No. 2001-13215
[Patent Document 2]: Japanese Patent Laid-Open No. 2004-77167

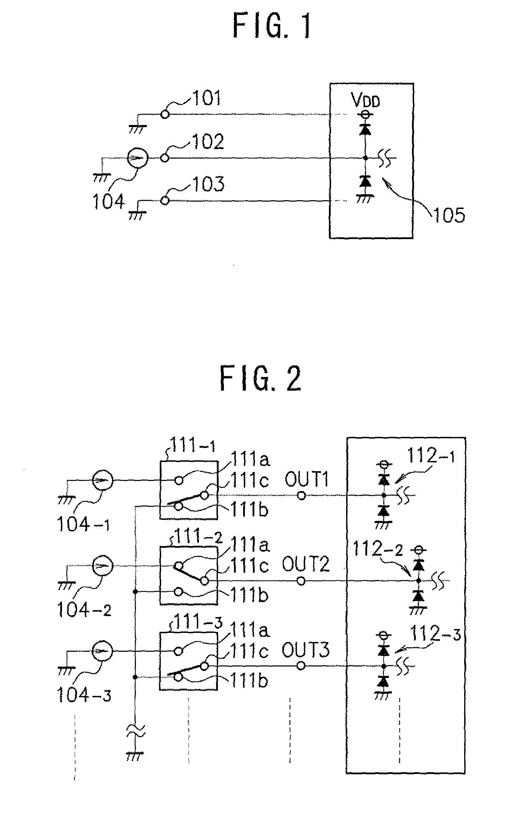

Either of test methods described in these Patent Documents 1, 2 discloses a method that a protection diode formed in a LSI is used to inspect. Figure 1 shows its operating principle. For example, when a wire connected to a terminal 102 of an LSI undergoes the open/short test, a constant current is applied from a constant current circuit 104 to the terminal 102, and another terminals 101, 103 adjacent to the terminal 102 are connected to ground. At this time, if there is not an abnormality that is an open/short fault, a protection diode 105 of the LSI operates normally, and as the result, a potential appears at the terminal 102 according to diode characteristics. On the one hand, if an open abnormality occurs in the terminal 102, the potential at the terminal 102 becomes a clamp potential with a constant current flowing. Also, if the terminal 102 is short-circuited to the adjacent terminals 102, 103, the potential at the terminal 102 becomes 0 V.

Therefore, a constant current is applied to a terminal under test and concurrently another adjacent terminal is connected to ground, and a potential at the terminal under test is measured, whereby an open test and a short test can be carried out at the same time. That is, it may be judged to be normal when a measured potential at that time follows the diode characteristics, to be an open fault when the measured potential is the clamp potential, and to be a short fault when 0 V. Then, with switching a terminal under test in turn, all terminals can undergo the open/short test.

In such way, in the technology described in Patent Documents 1, 2, to reduce an amount of time required for the open/short test, the open test and the short test are concurrently conducted. However, to switch a terminal under test in turn, switching operation is necessary, and a problem has occurred that the switching operation itself takes much time.

Conventionally, for this switching operation, a relay switch generally is used. For example, the method is such that, as shown in Figure 2, correspondingly to each of output terminals OUT1, OUT2, OUT3, .. of a semiconductor LSI, a relay switch 111₋₁, 111₋₂, 111₋₃, .. is respectively provided, a first branch contact 111a is connected to a constant current circuit 104₋₁, 104₋₂, 104-3, .., respectively, a second branch contact 111b is connected to ground, respectively, and a common contact 111c is connected to each of the output terminals OUT1, OUT2, OUT3, .. of the semiconductor LSI. To each of the output terminals OUT1, OUT2, OUT3, .., a protection diode 112₋₁, 112₋₂, 112₋₃, .. is connected, respectively. Then, only the relay switch 111₋₂ corresponding to the terminal under test OUT2 is connected on the side of the first branch contact 111a, and the relay switches 111₋₁, 111₋₃, .. corresponding to the other terminals are connected on the side of the second branch contact 111b.

However, the relay switch requires a considerable long time to be completely turned on to become stable after being switched, and an operating speed of the relay switch (time period for switching a signal) is not so fast. Therefore, the larger the number of terminals for test is, the longer the switching time in total becomes, and a problem occurs that the time necessary for the open/short test is increased.

Further, in the configuration in which, correspondingly to each of the output terminals OUT1, OUT2, OUT3, .., the relay switches 111₋₁, 111₋₂, 111₋₃, .. are respectively provided, it is necessary to provide a plurality of measuring instruments including the constant current circuits 104₋₁, 104₋₂, 104₋₃, .. correspondingly to each of the relay switches 111₋₁, 111₋₂, 111₋₃, ... respectively, resulting in also a problem that a circuit scale of an inspecting instrument is enlarged.

### [Disclosure of the Invention]

On the contrary, a method may be thought that a multiplexer circuit is used instead of a relay switch. The multiplexer circuit sequentially switches input signals applied to a plurality of input terminals in parallel, outputting a signal as a series signal one-by-one from an output terminal, and its time necessary for switching is shorter as compared to that of the relay switch. Further, only one constant current circuit connected to the multiplexer is necessary, and a circuit scale of an inspecting instrument can be reduced.

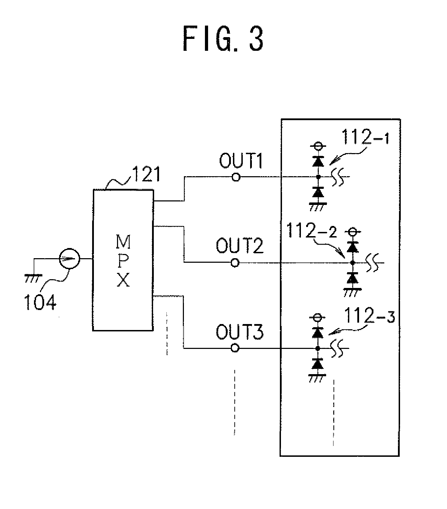

However, when the multiplexer circuit is used, as shown in Figure 3, any one of output terminals OUT1, OUT2, OUT3, .. of a semiconductor LSI may be selected by a multiplexer 121, but switching operation in which the other unselected output terminals are connected to ground can not be performed. Therefore, a problem arises that the open test can be conducted, but the short test can not be conducted at the same time.

The present invention has been made to solve these problems, and an object of the present invention is to reduce an amount of time necessary for the open/short test and a circuit scale of an inspecting instrument for conducting the open/short test.

To solve the problems, the present invention comprises: an odd multiplexer for sequentially switching a plurality of terminals connected to odd-numbered wires to select one-by-one; an even multiplexer for sequentially switching a plurality of terminals connected to even-numbered wires to select one-by-one; an odd relay switch for switching connection or disconnection of the odd multiplexer to a ground terminal; and an even relay switch for switching connection or disconnection of the even multiplexer to a ground terminal, in which, when one of the odd relay switch and the even relay switch does not select connection to the ground terminal, the other selects connection to the ground terminal.

According to the present invention as configured in such way, by using the multiplexer capable of operating in a higher speed as compared to the relay switch, while a terminal under test of a semiconductor LSI (wire under test) is sequentially selected in a high speed, another wire adjacent to the selected wire is switched to be connected to ground using the relay switch, then a potential appearing at a terminal of the multiplexer is measured, whereby the open/short test can be conducted in an extremely high speed.

In another aspect of the present invention, multiplexers are configured in a layered structure, and an odd relay switch and an even relay switch are provided between an odd multiplexer and an even multiplexer, and a multiplexer in a higher-level layer.

According to the present invention as configured in such way, by using multiplexers in a plurality of layers, the number of terminals can be decreased, and the number of constant current circuits connected to the terminals can be decreased, whereby, a circuit scale of a connected state inspecting instrument can be reduced.

In another aspect according to the present invention, a plurality of groups of odd multiplexers and even multiplexers are provided, a plurality of groups of odd relay switches and even relay switches are provided, and a plurality of groups of relay switches are provided between the plurality of groups of multiplexers and a multiplexer in a higher-level layer.

According to the another aspect of the present invention as configured in such way, from among the plurality of groups of odd multiplexers and even multiplexers in some layer, an odd (even) relay switch connected to a multiplexer concerned during a select period of a signal and an odd (even) relay switch for connecting to ground a wire adjacent to the wire of which signal is selected by the multiplexer are turned on, and the other relay switches except them are turned off, whereby a resistance component and a capacitance component of the multiplexer connected to the relay switch which is turned off can be separated off from a tree structure, decreasing a value of a time constant which affects an operating speed of the multiplexer. Therefore, a disadvantage that an overall operating speed of the connected state inspecting instrument is lowered by an increase of the time constant caused due to a cascade connection of the plurality of multiplexers can be prevented. Therefore, the open test and the short test on wiring can be conducted in an extremely high speed.

Further, in another aspect of the present invention, on periods of at least a part of a plurality of groups of relay switches are overlapped with each other.

According to the another aspect of the present invention as configured in such way, when some relay switch is turned on and the multiplexer connected to this relay switch selects a signal, at least more one relay switch is turned on. Accordingly, in switching the multiplexer to a next one used to select a signal, the relay switch connected to a new multiplexer, after switched, already established an on state, so that it is quite unnecessary to wait a long time until the relay switch is turned from "off" to "on". That is, when the relay switch is turned from "off" to "on", it is necessary to take a comparatively long time, but without waiting such a long time, a plurality of multiplexers can sequentially operate in a seamless manner. Accordingly, the open test and the short test on wiring can be conducted in an extremely high speed.

Further, in another aspect of the present invention, when on periods of at least a part of a plurality of groups of relay switches are overlapped with each other, on periods of the relay switches which are connected to terminals different from each other, of multiplexers in a higher-level layer are overlapped with each other.

According to the another aspect of the present invention as configured in such way, even if there are a plurality of relay switches which are concurrently turned on at one time, the plurality of relay switches except one relay switch are separated off from the tree structure since the multiplexer in the higher-level layer is not in a selective sate of signals in the plurality of relay switches except one relay switch, which results in that the resistance components or the capacitance components included in the multiplexers in a lower-level layer connected to the relay switches except the one relay switch can be separated off from a tree structure, decreasing the value of the time constant which affects the operating speed of the multiplexer. Accordingly, the open test and the short test on wiring can be conducted in an extremely high speed.

### [Brief Description of the Drawings]

Figure 1 is a view illustrating an operating principle of a method for conducting an open/short test using a protection diode formed in an LSI;
Figure 2 is a view illustrating an example of a usual circuit configuration for implementing switching operation required to sequentially switch a terminal under test;
Figure 3 is a view illustrating another example of a circuit configuration for implementing switching operation required to sequentially switch a terminal under test;
Figure 4 is a view illustrating an example of a configuration of a wiring connected state inspecting instrument according to a first embodiment;
Figure 5 is a timing chart illustrating an example of operation of the wiring connected state inspecting instrument according to the first embodiment;
Figure 6 is a view illustrating an example of a configuration of a wiring connected state inspecting instrument according to a second embodiment;
Figure 7 is a timing chart illustrating an example of operation of the wiring connected state inspecting instrument according to the second embodiment; and
Figure 8 is a view illustrating another example of a configuration of a wiring connected state inspecting instrument according to the second embodiment;

### [Detailed Description of the Preferred Embodiments]

### (First embodiment)

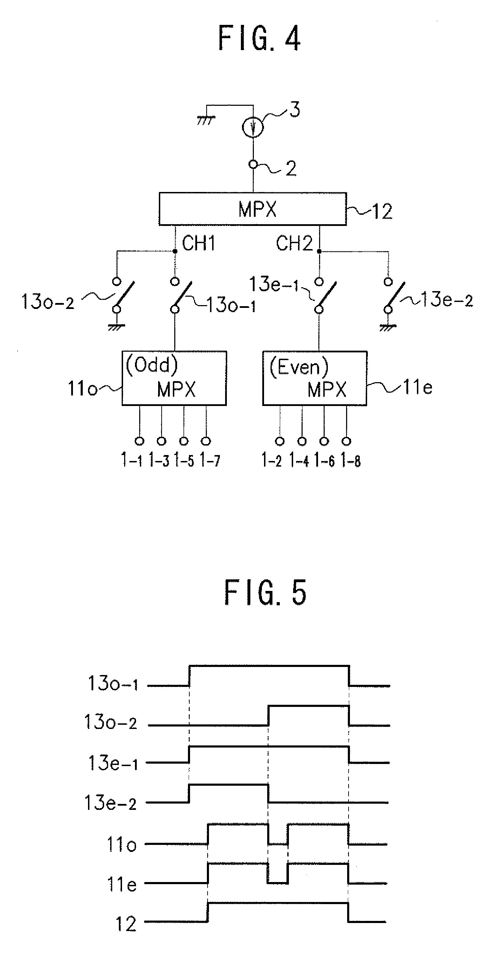

Now, one embodiment of the present invention will be hereinafter described with reference to the accompanying drawings. Figure 4 is a view illustrating an example of a configuration of a connected state inspecting instrument according to a first embodiment. As shown in Figure 4, the connected state inspecting instrument according to the first embodiment includes three multiplexers 11o, 11e, 12, which are connected in a tree structure. Among them, a first multiplexer 11o (corresponding to an odd multiplexer in the present invention) and a second multiplexer 11e (corresponding to an even multiplexer in the present invention) belong to a first layer, and a third multiplexer 12 belongs to a second layer which is higher by one layer than it.

Why the two multiplexers 11o, 11e rather than one multiplexer are provided in the first layer in such way is because a plurality of output terminals that a semiconductor LSI has can be divided into odd-numbered output terminals and even-numbered output terminals to separately process.

Each of the plurality of multiplexers 11o, 11e, 12 sequentially switches the plurality of terminals to select one-by-one, respectively. That is, the first multiplexer 11o sequentially switches four terminals 1₋₁, 1₋₃, 1₋₅, 1₋₇ to select one-by-one. The second multiplexer 11e sequentially switches four terminals 1₋₂, 1₋₄, 1₋₆, 1₋₈ to select one-by-one. The third multiplexer 12 sequentially switches two terminals CH1, CH2 to select one-by-one from. To ahead the other terminal 2 of the third multiplexer 12, a constant current circuit 3 is connected.

Generally, a multiplexer is used for sequentially switching a plurality of signals provided from a plurality of input terminals in parallel and outputting a signal one-by-one from one output terminal. In this embodiment, on the contrary, the multiplexer is used for sequentially assigning to output a signal provided from one input terminal, to a plurality of terminals. That is, in the first and second multiplexer 11o, 11e, the terminals 1₋₁ to 1₋₈ are used for an output terminal. Further, in the third multiplexer 12, the terminals CH1, CH2 are used for an output terminal. When the multiplexer is formed of an analog switch using CMOS process, the multiplexer can be used in such way.

The four output terminals 1₋₁, 1₋₃, 1₋₅, 1₋₇ that the first multiplexer 11o has are connected to odd-numbered output terminals of a semiconductor LSI to be tested (not shown). Further, the four output terminals 1₋₂, 1₋₄, 1₋₆, 1-₈ that the second multiplexer 11e has are connected to even-numbered output terminals of the semiconductor LSI. Suffix number 1 to 8 attached to a symbol of each output terminal 1₋₁ to 1₋₈ respectively corresponds to an arrangement order of the output terminals of the semiconductor LSI. That is, from among eight wires connected to the eight output terminals and adjacent to each other, the odd-numbered wires are connected to the first multiplexer 11o and the even-numbered wires are connected to the second multiplexer 11e. In addition, to each of the output terminals of the semiconductor LSI to be tested, a protection diode is connected, respectively.

In this embodiment, between the two multiplexers 11o, 11e in the first layer of the tree structure and the third multiplexer 12 in the second layer higher by one layer than the first layer, four relay switches 13o-₁, 13o₋₂, 13e₋₁, 13e₋₂ are provided. A first and second relay switches 13o₋₁, 13o₋₂ correspond to the odd relay switch in the present invention, and a third and fourth relay switches 13e₋₁, 13e₋₂ correspond to the even relay switch in the present invention.

The first relay switch 13o₋₁ is provided between an input terminal of the first multiplexer 11o and a first output terminal CH1 of the third multiplexer 12. The second relay switch 13o₋₂ is provided between ground (ground terminal) and the first output terminal CH1 of the third multiplexer 12. Each input terminal of the two relay switches 13o₋₁, 13o₋₂ is connected to one signal line and connected to the first output terminal CH1 of the third multiplexer 12.

Further, the third relay switch 13e-₁ is provided between an input terminal of the second multiplexer 11e and a second output terminal CH2 of the third multiplexer 12. The fourth relay switch 13ₑ₋₂ is provided between ground (ground terminal) and the second output terminal CH2 of the third multiplexer 12. Each input terminal of the two relay switches 13ₑ₋₁, 13ₑ₋₂ is connected to one signal line and connected to the second output terminal CH2 of the third multiplexer 12.

Next, operation of the connected state inspecting instrument according to the first embodiment as configured in a way described above will be described. Figure 5 is a timing chart illustrating an example of the operation of the connected state inspecting instrument according to the first embodiment.

As shown in Figure 5, first, the first relay switch 13o₋₁, the third relay switch 13e₋₁ and the fourth relay switch 13e₋₂ are turned on, and the second relay switch 13o₋₂ is turned off. Accordingly, to the first output terminal CH1 of the third multiplexer 12 in the second layer, the odd-numbered wires of the semiconductor LSI are connected through the first multiplexer 11o in the first layer, and the even-numbered wires are connected to ground through the second multiplexer 11e, the third relay switch 13e₋₁ and the fourth relay switch 13e₋₂.

Because an on state of the first relay switch 13o₋₁ is not yet established immediately after it is turned on, at the time approximately when an on state of the first relay switch 13o₋₁ is established, the first multiplexer 11o is brought into operation (on state). Further, because an on state of the third relay switch 13e₋₁ and the fourth relay switch 13e₋₂ is not yet established immediately after they are turned on, at the time approximately when an on state of the third relay switch 13ₑ₋₁ and the fourth relay switch 13ₑ₋₂ is established, the second multiplexer 11e is brought into operation (on state). Here, because the multiplexer, as compared to the relay switch, takes an extremely shorter time until an on state is established, the multiplexer can immediately come into operation.

Also, the third multiplexer 12 is turned on at the same time as the first multiplexer 11o or before it. At this time, the third multiplexer 12 is switched to select the first output terminal CH1.

Accordingly, a state is achieved equivalent to such that only the odd-numbered wires connected to the odd-numbered output terminals that the semiconductor LSI to be tested has are connected to the constant current circuit 3 through the two multiplexers 11o, 12, and the even-numbered wires connected to the even-numbered output terminals are connected to ground. At this time, a signal with a constant current provided by the constant current circuit 3 is sequentially output from output terminals 1₋₁, 1₋₃, 1₋₅, 1₋₇ of the first multiplexer 11o through the third multiplexer 12 and the first relay switch 13o₋₁.

The first multiplexer 11o brought into operation sequentially switches and outputs the signal provided by the constant current circuit 3 through the third multiplexer 12 and the first relay switch 13o₋₁ to the four output terminals 1₋₁, 1₋₃, 1₋₅, 1₋₇.

Further, the second multiplexer 11e which is brought into operation at the same time as the first multiplexer 11o sequentially switches and selects the four output terminals 1₋₂, 1₋₄, 1₋₆, 1₋₈. Accordingly, the even-numbered wires of the semiconductor LSI connected to the four output terminals 1₋₂, 1₋₄, 1₋₆, 1₋₈ are sequentially connected to ground through the third relay switch 13e₋₁ and the fourth relay switch 13e₋₂.

For example, when the first multiplexer 11o selects the first output terminal 1₋₁, the second multiplexer 11e also selects the first output terminal 1₋₂. When the first multiplexer 11o selects the second output terminal 1₋₃, the second multiplexer 11e also selects the second output terminal 1₋₄. When the first multiplexer 11o selects the third output terminal 1₋₅, the second multiplexer 11e also selects the third output terminal 1₋₆.

Further, when the first multiplexer 11o selects the fourth output terminal 1₋₇, the second multiplexer 11e also selects the fourth output terminal 1₋₈.

As described above, to ahead the four output terminals 1₋₁, 1₋₃, 1₋₅, 1₋₇, the protection diodes of the semiconductor LSI (not shown) are respectively connected. Therefore, when a constant current is supplied from the constant current circuit 3 to the semiconductor LSI through the input terminal 2, the third multiplexer 12, the first relay switch 13o₋₁ and the first multiplexer 11o, then, by measuring a potential appearing at the input terminal 2, the open/short test with respect to the odd-numbered wires of the semiconductor LSI can be sequentially conducted using the protection diodes.

That is, for example, when the first multiplexer 11o selects the first output terminal 1₋₁, a first wire connected to the first output terminal of the semiconductor LSI corresponding to it is connected to the constant current circuit 3 through the first multiplexer 11o, the first relay switch 13o₋₁ and the third multiplexer 12. On the one hand, when the first wire of the semiconductor LSI is connected to the constant current circuit 3, a second wire adjacent to this is connected to ground through the second multiplexer 11e, the third relay switch 13e₋₁ and the fourth relay switch 13e₋₂. Accordingly, when the first wire does not have an open fault and a short fault does not occur between the first wire and the second wire, the protection diode works normally, and as the result, the potential appears at the input terminal 2 according to the diode characteristics. On the one hand, when the first wire has an open fault, the potential at the input terminal 2 becomes a predetermined clamp voltage. Further, when a short fault occurs between the first wire and the second wire, the potential at the input terminal 2 becomes 0 V.

Therefore, the first relay switch 13o₋₁, the third relay switch 13e₋₁ and the fourth relay switch 13e₋₂ are turned on, and the first multiplexer 110 selects the first output terminal 1-₁ and the second multiplexer 11e selects the first output terminal 1₋₂, then, by measuring the potential appearing at the input terminal 2, the open test with respect to the first wire and the short test between the first and the second wires can be concurrently conducted. That is, when the measured potential at that time is a potential following the diode characteristics, it can be judged to be normal, and when the potential is a clamp voltage, it can be judged to be open, and when 0 V, it is short. Then, the first multiplexer 11o and the second multiplexer 11e sequentially switch and select an output terminal, whereby the open/short test with respect to the odd-numbered wires of the semiconductor LSI can be sequentially conducted.

After the first multiplexer 11o selects all the output terminals 1₋₁, 1₋₃, 1₋₅, 1₋₇, next, the fourth relay switch 13e₋₂ is turned off, and the second relay switch 13o₋₂ is turned on. Accordingly, a state is brought that, to the second output terminal CH2 of the third multiplexer 12 in the second layer, the even-numbered wires of the semiconductor LSI are connected through the second multiplexer 11e in the first layer, and the odd-numbered wires are connected to ground through the first multiplexer 11o, the first relay switch 13o₋₁ and the second relay switch 13o₋₂.

Because, immediately after the second relay switch 13o₋₂ is turned on, an on state is not yet established, at the time approximately when an on state of the second relay switch 13o₋₂ is established, the first multiplexer 11o is brought into operation (on state). Further, at the approximately same time as this, the second multiplexer 11e is also brought into operation (on state). Here, because the multiplexer, as compared to the relay switch, takes an extremely shorter time until an on state is established, the multiplexer can immediately come into operation.

At this time, the third multiplexer 12 has already achieved its operation state and is switched to select the second output terminal CH2. In addition, the third multiplexer 12 can also switch in a high speed from selection of the first output terminal CH1 to selection of the second output terminal CH2.

Accordingly, a state is achieved equivalent to such that only the even-numbered wires connected to the even-numbered output terminals that the semiconductor LSI to be tested has are connected to the constant current circuit 3 through the two multiplexers 11e, 12, and the odd-numbered wires connected to the odd-numbered output terminals are connected to ground. At this time, a signal with a constant current provided by the constant current circuit 3 is sequentially output from the output terminals 1₋₂, 1₋₄, 1₋₆, 1₋₈ of the second multiplexer 11e through the third multiplexer 12 and the third relay switch 13e₋₁.

The second multiplexer 11e brought into operation sequentially switches and outputs the signal provided by the constant current circuit 3 through the third multiplexer 12 and the third relay switch 13e₋₁, to the four output terminals 1₋₂, 1₋₄, 1₋₆, 1₋₈.

Further, the first multiplexer 11₀ which is brought into operation at the same time as the second multiplexer 11e sequentially switches and selects the four output terminals 1₋₁, 1₋₃, 1₋₅, 1₋₇. Accordingly, the odd-numbered wires of the semiconductor LSI connected to the four output terminals 1₋₁, 1₋₃, 1₋₅, 1₋₇ are sequentially connected to ground through the first relay switch 13o₋₁ and the second relay switch 13o₋₂.

For example, when the second multiplexer 11e selects the first output terminal 1₋₂, the first multiplexer 11o selects the second output terminal 1₋₃. When the second multiplexer 11e selects the second output terminal 1₋₄. the first multiplexer 11o selects the third output terminal 1₋₅. When the second multiplexer 11e selects the third output terminal 1₋₆, the first multiplexer 11o selects the fourth output terminal 1₋₇. Further, when the second multiplexer 11e selects the fourth output terminal 1₋₈, the first multiplexer 11o selects the first output terminal 1₋₁.

In addition, a wire adjacent to an eighth wire connected to the fourth output terminal 1₋₈ of the second multiplexer 11e is a seventh wire connected to the fourth output terminal 1₋₇ of the first multiplexer 11o. However, a group of the seventh wire and the eighth wire is already selected, when the second relay switch 13o₋₂ is off and the fourth relay switch 13e₋₂ is on, and so, here, the first multiplexer 11o does not select the fourth output terminal 1₋₇ and selects the first output terminal 1₋₁. However, an output terminal selected here may be any of the four output terminals 1₋₁, 1₋₃, 1₋₅, 1₋₇.

As described above, to ahead the four output terminals 1₋₂, 1₋₄, 1₋₆, 1₋₈, the protection diodes of the semiconductor LSI (not shown) are connected. Accordingly, when a constant current is supplied from the constant current circuit 3 to the semiconductor LSI through the input terminal 2, the third multiplexer 12, the third relay switch 13e₋₁ and the second multiplexer 11e, then, by measuring the potential appearing at the output terminal 2, the open/short test with respect to the even-numbered wires of the semiconductor LSI can be sequentially conducted using the protection diodes.

For example, the first relay switch 13o₋₁, the second relay switch 13o₋₂ and the third relay switch 13e₋₁ are turned on, and at the same time, the second multiplexer 11e selects the first output terminal 1₋₂ and the first multiplexer 11e selects the second output terminal 1₋₃, then, by measuring the potential appearing at the input terminal 2 at this time, the open test with respect to the second wire and the short test between the second and the third wires can be concurrently conducted (The short test between the first wire and the second wire was already conducted previously). That is, when the measured potential at that time is a potential following the diode characteristics, it can be judged to be normal, and when the potential is a clamp voltage, it can be judged to be open, and when 0 V, it is short. Then, the first multiplexer 11o and the second multiplexer 11e sequentially switch and select an output terminal, whereby, the open/short test with respect to the even-numbered wires of the semiconductor LSI can be sequentially conducted.

As described above in detail, according to the first embodiment, the wires of the semiconductor LSI are sequentially selected in a high speed using the multiplexers 11o, 11e capable of operating in a higher speed as compared to the relay switch, and another wire adjacent to the selected wire is switched to be connected to ground through the relay switches 13o₋₂, 13ₑ₋₂, then, by measuring the potential appearing at the input terminal 2, the open/short test using the protection diodes can be conducted in an extremely high speed. Further, because the input terminal 2 is limited to one input terminal using the three multiplexers 11o, 11e and 12, only one constant current circuit 3 connected to it is necessary, reducing the circuit scale of the connected state inspecting instrument.

### (Second embodiment)

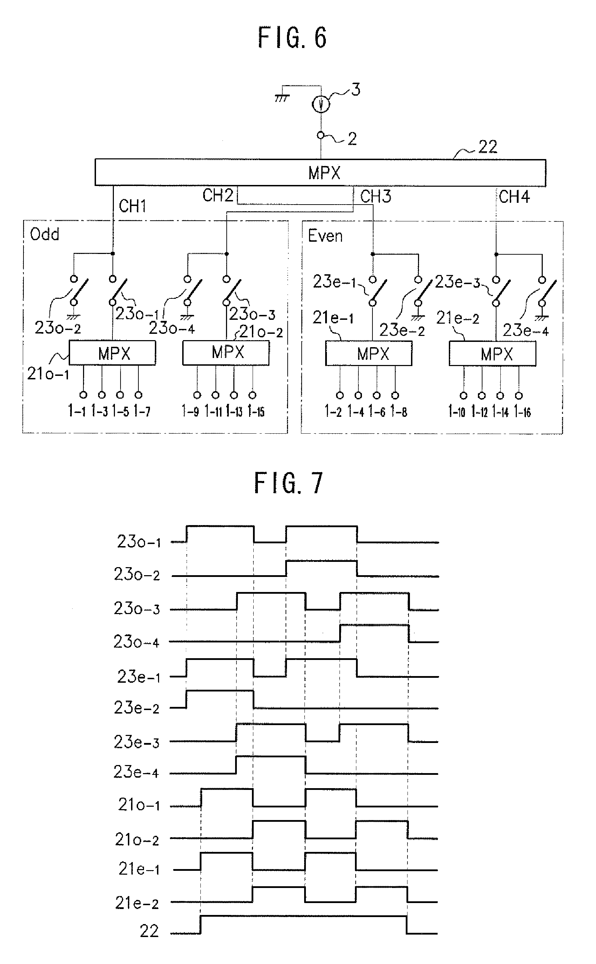

Next, a second embodiment of the present invention will be described with reference to the drawings. Figure 6 is a view illustrating an example of a configuration of a connected state inspecting instrument according to the second embodiment. As shown in Figure 6, the connected state inspecting instrument according to the second embodiment includes five multiplexers 21o₋₁, 21o₋₂, 21e₋₁, 21e₋₂ and 22, which are connected in a tree structure. Among them, a first to fourth multiplexers 21o₋₁, 21o₋₂, 21e₋₁, 21e₋₂ belong to a first layer and a fifth multiplexer 22 belongs to a second layer which is higher by one layer than the first layer.

The first and second multiplexers 21o₋₁, 21o₋₂ in the first layer belong to an odd block "Odd" and a third and fourth multiplexers 21e₋₁, 21e₋₂ belong to an even block "Even". Why, in the first layer, the multiplexers are divided into the multiplexers 21o₋₁, 21o₋₂ of the odd block "Odd" and the multiplexers 21e₋₁, 21e₋₂ of the even block "Even" is because a plurality of output terminals that a semiconductor LSI has are divided into odd-numbered output terminals and even-numbered output terminals to process. Further, why a plurality of multiplexers is provided in the same block is because parallel processing, in which on periods of a plurality of relay switches provided correspondingly to the multiplexers are overlapped with each other as described below, can be performed.

Each of the plurality of multiplexers 21o₋₁, 21o₋₂, 21e₋₁, 21e₋₂ and 22 sequentially switches and selects one-by-one the plurality of output terminals. That is, the first multiplexer 21o₋₁ switches and selects one-by-one four terminals 1₋₁, 1₋₃, 1₋₅, 1₋₇. The second multiplexer 21o₋₂ switches and selects one-by-one four terminals 1₋₉, 1₋₁₁, 1₋₁₃, 1₋₁₅. The third multiplexer 21e₋₁ switches and selects one-by-one four terminals 1₋₂, 1₋₄, 1₋₆, 1₋₆. The fourth multiplexer 21e₋₂ switches and selects one-by-one four terminals 1₋₁₀, 1₋₁₂, 1₋₁₄, 1₋₁₆. The fifth multiplexer 22 switches and selects one-by-one four terminals CH1, CH2, CH3, CH4. To ahead the other terminal 2 of the fifth multiplexer 22, a constant current circuit 3 is connected.

In this embodiment, the multiplexer is used for sequentially assigning to output a signal provided by one input terminal to a plurality of terminals. That is, in the first to fourth multiplexers 21o₋₁, 21o₋₂, 21e₋₁, 21e₋₂, the terminals 1₋₁ to 1₋₁₆ are used for an output terminal. Further, in the fifth multiplexer 22, the terminals CH1 to CH4 are used for an output terminal.

Eight output terminals 1₋₁, 1₋₃, 1₋₅, 1₋₇, 1₋₉, 1₋₁₁, 1₋₁₃, 1₋₁₅ that the first and second multiplexers 21o₋₁, 21o₋₂ in the odd block "Odd" have are connected to odd-numbered output terminals of the semiconductor LSI to be tested (not shown). Further, eight output terminals 1₋₂, 1₋₄, 1₋₆, 1₋₈, 1₋₁₀, 1₋₁₂, 1₋₁₄, 1₋₁₆ that the third and fourth multiplexers 21e₋₁, 21e₋₂ in the even block "Even" have are connected to even-numbered output terminals of the semiconductor LSI. A suffix number 1 to 16 attached to each symbol of the output terminals 1₋₁ to 1₋₁₆ corresponds to an arrangement order of the output terminals of the semiconductor LSI. That is, from among sixteen wires connected to the sixteen output terminals and adjacent to each other, odd-numbered wires are connected to the first and second multiplexers 21o₋₁, 21o₋₂, and even-numbered wires are connected to the third and fourth multiplexers 21e₋₁, 21e₋₂. In addition, to each output terminal of the semiconductor LSI to be tested, a protection diode is connected, respectively.

In this embodiment, between the four multiplexers 21o₋₁, 21o_{-2,} 21ₑ₋₁, 21ₑ₋₂ in the first layer of a tree structure and the fifth multiplexer 22 in the second layer higher by one layer than the first layer, eight relay switches 23o₋₁, 23o₋₂, 23o₋₃, 23o₋₄, 23e₋₁, 23e₋₂, 23e₋₃, 23e₋₄ are provided. A first to fourth relay switches 23o₋₁ to 23o₋₄ belong to the odd block "Odd", and a fifth to eighth relay switches 23e₋₁ to 23e₋₄ belong to the even block "Even". The first to fourth relay switches 23o₋₁ to 23o₋₄ belonging to the odd block "Odd" correspond to odd relay switches of the present invention and the fifth to eighth relay switches 23e₋₁ to 23e₋₄ belonging to the even block "Even" correspond to even relay switches of the present invention.

The first relay switch 23o₋₁ is provided between an input terminal of the first multiplexer 21o₋₁ and a first output terminal CH1 of the fifth multiplexer 22. The second relay switch 23o₋₂ is provided between ground (ground terminal) and the first output terminal CH1 of the fifth multiplexer 22. Each input terminal of the two relay switches 23o₋₁, 23o₋₂ is connected to one signal line and connected to the first output terminal CH1 of the fifth multiplexer 22.

The third relay switch 23o₋₃ is provided between an input terminal of the second multiplexer 21o₋₂ and a third output terminal CH3 of the fifth multiplexer 22. The fourth relay switch 23o₋₄ is provided between ground (ground terminal) and the third output terminal CH3 of the fifth multiplexer 22. Each input terminal of the two relay switches 23o₋₃, 23o₋₄ is connected to one signal line and connected to the third output terminal CH3 of the fifth multiplexer 22.

The fifth relay switch 23e₋₁ is provided between an input terminal of the third multiplexer 21e₋₁ and a second output terminal CH2 of the fifth multiplexer 22. The sixth relay switch 23e₋₂ is provided between ground (ground terminal) and the second output terminal CH2 of the fifth multiplexer 22. Each input terminal of the two relay switches 23e₋₁, 23e₋₂ is connected to one signal line and connected to the second output terminal CH2 of the fifth multiplexer 22.

The seventh relay switch 23e₋₃ is provided between an input terminal of the fourth multiplexer 21e₋₂ and a fourth output terminal CH4 of the fifth multiplexer 22. The eighth relay switch 23e₋₄ is provided between ground (ground terminal) and the fourth output terminal CH4 of the fifth multiplexer 22. Each input terminal of the two relay switches 23e₋₃, 23e₋₄ is connected to one signal line and connected to the fourth output terminal CH4 of the fifth multiplexer 22.

Next, operation of the connected state inspecting instrument according to the second embodiment as configured in a way described above will be described. Figure 7 is a timing chart illustrating an example of the operation of the connected state inspecting instrument according to the second embodiment.

As shown in Figure 7, first, the first relay switch 23o₋₁, the fifth relay switch 23e₋₁ and the sixth relay switch 23e₋₂ are turned on, and the other relay switches 23o₋₂ to 23o₋₄, 23e₋₃, 23e₋₄ are turned off. Accordingly, to the first output terminal CH1 of the fifth multiplexer 22 in the second layer, a first, third, fifth and seventh wires of the semiconductor LSI are connected through the first multiplexer 21o₋₁ in the first layer, and a second, fourth, sixth and eighth wires are connected to ground through the third multiplexer 21e₋₁, the fifth relay switch 23e₋₁ and the sixth relay switch 23e₋₂.

Under these conditions, before the first relay switch 23o₋₁, the fifth relay switch 23e₋₁ and the sixth relay switch 23e₋₂ are turned off, the third relay switch 23o₋₃, the seventh relay switch 23e₋₃ and the eighth relay switch 23e₋₄ are turned on. Accordingly, the latter half of an on period of the first relay switch 23o₋₁ and the first half of an on period of the third relay switch 23o₋₃ are overlapped with each other. Further, the latter half of an on period of the fifth relay switch 23e₋₁ and the first half of an on period of the seventh relay switch 23e₋₃ are overlapped with each other. Moreover, the latter half of an on period of the sixth relay switch 23e₋₂ and the first half of an on period of the eighth relay switch 23e₋₄ are overlapped with each other.

Because, immediately after the first relay switch 23o₋₁ is turned on, an on state thereof is not yet established, in the latter half of an on period of the first relay switch 23o₋₁ (at the time approximately when an on state of the first relay switch 23o₋₁ is established), the first multiplexer 21o₋₁ is brought into operation (on state). Further, because, immediately after the fifth relay switch 23e₋₁ and the sixth relay switch 23e₋₂ are turned on, an on state thereof is not yet established, in the latter half of an on period of the fifth relay switch 23e₋₁ and the sixth relay switch 23e₋₂ (at the time approximately when an on state of the fifth relay switch 23e₋₁ and the sixth relay switch 23e₋₂ is established), the third multiplexer 21e₋₁ is brought into operation (on state). Here, because the multiplexer, as compared to the relay switch, takes an extremely shorter time until an on state is established, the multiplexer can immediately come into operation.

Also, the fifth multiplexer 22 is turned on at the same time as the first multiplexer 21o₋₁ or before it. At this time, the fifth multiplexer 22 is switched to select the first input terminal CH1.

Accordingly, a state is achieved equivalent to such that only the first, third, fifth and seventh wires connected to the first, third, fifth and seventh output terminals that the semiconductor LSI to be tested has are connected to the constant current circuit 3 through the two multiplexers 21o₋₁, 22, and the second, fourth, sixth and eighth wires adjacent to them are connected to ground. At this time, a signal with a constant current provided by the constant current circuit 3 is output sequentially from the output terminals 1₋₁, 1₋₃, 1₋₅, 1₋₇ of the first multiplexer 21o₋₁ through the fifth multiplexer 22 and the first relay switch 23o₋₁.

The first multiplexer 21o₋₁ brought into operation sequentially switches and outputs the signal provided by the constant current circuit 3 through the fifth multiplexer 22 and the first relay switch 23o₋₁, to the four output terminals 1₋₁, 1₋₃, 1₋₅, 1₋₇.

Further, the third multiplexer 21ₑ₋₁, which is brought into operation at the same time as the first multiplexer 21o₋₁, sequentially switches and selects the four output terminals 1₋₂, 1₋₄, 1₋₆, 1₋₈. Accordingly, the second, fourth, sixth and eighth wires of the semiconductor LSI connected to the four output terminals 1₋₂, 1₋₄, 1₋₆, 1₋₈ are sequentially connected to ground through the fifth relay switch 23e₋₁ and the sixth relay switch 23e₋₂. Here, similarly to the first embodiment, when the first multiplexer 21o₋₁ selects an i^{th} (i = 1, 2, 3, 4) output terminal 1₋₁, 1₋₃, 1₋₅, 1₋₇, the second multiplexer 21e₋₁ also selects an i^{th} output terminal 1-₂, 1₋₄, 1₋₆, 1₋₈.

In addition, when the first and third multiplexers 21o₋₁, 21e₋₁ operate in such way, the other second and fourth multiplexers 21o₋₂, 21e₋₂ may be in an inactive condition, or in operation (an active condition). In the example shown in Figure 7, they are in an inactive condition. It is because of the following reason.

That is, each of the multiplexers has load with a resistance component (R) and a capacitance component (C). The resistance component (R) and the capacitance component (C) largely affect an operating speed of the multiplexers (signal switching time). That is, when the multiplexer switches a signal to be selected, the product (CR) of the resistance component (R) and the capacitance component (C) affects, as a time constant, a waiting time period to establish an on state of a selected signal line and stably read in the signal. Therefore, even if one component is increased, a signal switching speed of the multiplexers is lowered. Then, to enhance the operating speed of the multiplexers, it is desired to reduce values of the resistance component (R) and the capacitance component (C).

When a multiplexer circuit is configured in a manner that a plurality of multiplexers are connected in the tree structure as shown in Figure 6, the resistance component (R) and the capacitance component (C) of the multiplexer in each layer connected by a selected signal line are connected to each other in a cascade arrangement, accordingly each component is summed up, resulting in a larger time constant. For example, when a signal line from any one of output terminals is selected in the multiplexer of a higher-level layer, and a signal line from the multiplexer of the higher-level layer is selected in the multiplexer of a lower-level layer thereof, then a resistance component (R_{D}) and a capacitance component (C_{D}) that the multiplexer in the lower-level layer has and a resistance component (R_{U}) and a capacitance component (C_{U}) that the multiplexer in the higher-level layer has are connected in a cascade arrangement, respectively, resulting in a large time constant such as (R_{D} + R_{U}) × (C_{D} + C_{U}).

On the contrary, in the second embodiment, the relay switches 23o₋₁ to 23o₋₄, 23e₋₁ to 23e₋₄ are provided between the multiplexers in the lower-level layer 21o₋₁, 21o₋₂, 21e₋₁, 21e₋₂ and the multiplexer in the higher-level layer 22, so that connection to the multiplexer in the higher-level layer 22 is suitably divided into CH1 to CH4. Therefore, when the first and third multiplexers 21o₋₁, 21e₋₂ operate, the third relay switch 23o₋₃ and the seventh relay switch 23e₋₃ connected to the second and fourth multiplexers 21o₋₂, 21e₋₂ are yet in an off state. In addition, there is a period during which an on state of the third relay switch 23o-₃ and the seventh relay switch 23e₋₃ partially overlaps with that of the first relay switch 23o₋₁ and the fifth relay switch 23e₋₁, but during this period, an on state is not established. Therefore, the second and fourth multiplexers 21o₋₂, 21e₋₂ are separated off from a signal selecting line.

Further, when the fifth multiplexer 22 in the second layer selects the first output terminal CH1, the fifth multiplexer 22 can not select the second to fourth input terminals CH2 to CH4. Accordingly, even when the third multiplexer 21e₋₁ is operating, it also is separated off from the selecting line.

That is, only the first multiplexer 21o₋₁ and the fifth multiplexer 22 are connected to each other through the first relay switch 23o₋₁. Therefore, even if the second to fourth multiplexers 21o₋₂, 22e₋₁, 21e₋₂ are operating, these resistance components (R) and capacitance components (C) are not connected in a cascade arrangement, so that the value of the time constant (CR) does not become large. Accordingly, when the first and third multiplexers 21o₋₁, 21e₋₁ are operating, the other second and fourth multiplexers 21o₋₂, 21e₋₂ may be in an inactive condition or in operation.

As described above, to ahead the four output terminals 1₋₁, 1₋₃, 1₋₅, 1₋₇, the protection diodes of the semiconductor LSI (not shown) are connected. Therefore, when a constant current is supplied from the constant current circuit 3 to the semiconductor LSI through the input terminal 2, the fifth multiplexer 22, the first relay switch 23o₋₁ and the first multiplexer 21o₋₁, then, by measuring a potential appearing at the input terminal 2, the open/short test with respect to the first, third, fifth and seventh wires of the semiconductor LSI can be sequentially conducted using the protection diode.

That is, for example, when the first multiplexer 21o₋₁ selects the first output terminal 1₋₁, a first wire connected to the first output terminal of the semiconductor LSI corresponding to it is connected to the constant current circuit 3 through the first multiplexer 21o₋₁, the first relay switch 23o₋₁ and the fifth multiplexer 22. On the one hand, when the first wire of the semiconductor LSI is connected to the constant current circuit 3, a second wire adjacent to it is connected to ground through the third multiplexer 21e₋₁, the fifth relay switch 23e₋₁ and the sixth relay switch 23e₋₂. Therefore, when the first wire does not have an open fault and a short fault does not occur between the first wire and second wire, then the protection diode operates normally, and as the result, the potential appears at the input terminal 2 according to the diode characteristics. On the one hand, when the first wire has an open fault, the potential at the input terminal 2 becomes a predetermined clamp voltage. Further, when a short fault occurs between the first wire and the second wire, the potential at the input terminal 2 becomes 0 V.

Therefore, the first relay switch 23o₋₁, the fifth relay switch 23e₋₁ and the sixth relay switch 23e₋₂ are turned on, and the first multiplexer 21o₋₁ selects the first output terminal 1₋₁ and the third multiplexer 21e₋₁ selects the first output terminal 1₋₂, then, by measuring the potential appearing at the input terminal 2 at that time, the open test with respect to the first wire and the short test between the first wire and the second wire can be concurrently conducted. That is, when the measured potential at that time is a potential following the diode characteristics, it can be judged to be normal, and when the potential is a clamp voltage, it can be judged to be open, and when 0 V, to be short. Then, the first multiplexer 21o₋₁ and the third multiplexer 21e₋₁ sequentially switch and select an output terminal, whereby, the open/short test with respect to the first, third, fifth and seventh wires of the semiconductor LSI can be sequentially conducted.

After the first multiplexer 21o₋₁ selects all the output terminals 1₋₁, 1₋₃, 1₋₅, 1₋₇, next, the first relay switch 23o₋₁, the fifth relay switch 23e₋₁ and the sixth relay switch 23e₋₂ are switched to be off, and the first multiplexer 21o₋₁ and the third multiplexer 21e₋₁ are switched to be off and the second multiplexer 21o₋₁ and the fourth multiplexer 21e₋₂ are switched to be on.

As described above, an on period of the first relay switch 23o₋₁ and that of the third relay switch 23o₋₃ are partially overlapped with each other, an on period of the fifth relay switch 23e₋₁ and that of the seventh relay switch 23e₋₃ are partially overlapped with each other, and an on period of the sixth relay switch 23o₋₂ and that of the eighth relay switch 23e₋₄ are partially overlapped. Accordingly, when the second multiplexer 21o₋₂ and the fourth multiplexer 21e₋₂ are switched to operate after operation of the first multiplexer 21o₋₁ and the third multiplexer 21e₋₁ is completed, the third relay switch 23o₋₃, the seventh relay switch 23e₋₃ and the eighth relay switch 23e₋₄ have already achieved their on state. Therefore, after completion of operation of the first multiplexer 21o₋₁ and the third multiplexer 21e₋₁, without waiting for the third relay switch 23o₋₃, the seventh relay switch 23e₋₃ and the eighth relay switch 23e₋₄ to achieve their on state, it is allowed to immediately switch to the second multiplexer 21o₋₂ and the fourth multiplexer 21e₋₂ to operate.

When an on state of the third relay switch 23o₋₃, the seventh relay switch 23e₋₃ and the eighth relay switch 23e₋₄ is established, a ninth, eleventh, thirteenth and fifteenth wires of the semiconductor LSI are connected to the third output terminal CH3 of the fifth multiplexer 22 in the second layer through the second multiplexer 21o₋₂ in the first layer, and a tenth, twelfth, fourteenth and sixteenth wires are connected to ground through the fourth multiplexer 21e₋₂, the seventh relay switch 23e₋₃ and the eighth relay switch 23e₋₄.

At this time, the fifth multiplexer 22 is in operation and switched to select the third input terminal CH3. In addition, the fifth multiplexer 22 can also switch in a high speed from selection of the first output terminal CH1 to selection of the third output terminal CH3.

Accordingly, a state is achieved equivalent to such that only the ninth, eleventh, thirteenth and fifteenth wires connected to the ninth, eleventh, thirteenth and fifteenth output terminals that the semiconductor LSI to be tested has are connected to the constant current circuit 3 through the two multiplexers 21o₋₂, 22, and the tenth, twelfth, fourteenth and sixteenth wires adjacent to them are connected to ground. At this time, a signal with a constant current provided by the constant current circuit 3 is output sequentially from the output terminals 1₋₉, 1₋₁₁, 1₋₁₃, 1₋₁₅ of the second multiplexer 21o₋₂ through the fifth multiplexer 22 and the third relay switch 23o₋₃.

The second multiplexer 21o₋₂ brought into operation under these conditions sequentially switches and outputs the signal provided from the constant current circuit 3 through the fifth multiplexer 22 and the third relay switch 23o₋₃, to the four output terminals 1₋₉, 1₋₁₁, 1₋₁₃, 1₋₁₅.

Further, the fourth multiplexer 21e₋₂ brought into operation at the same time as the second multiplexer 21o₋₂ sequentially switches and selects the four output terminals 1₋₁₀, 1₋₁₂, 1₋₁₄, 1₋₁₆. Accordingly, a tenth, twelfth, fourteenth and sixteenth wires of the semiconductor LSI connected to the four output terminals 1₋₁₀, 1₋₁₂, 1₋₁₄, 1₋₁₆ are sequentially connected to ground through the seventh relay switch 23e₋₃ and the eighth relay switch 23e₋₄. Also here, when the second multiplexer 21o₋₂ selects an i^{th} (i = 1, 2, 3, 4) output terminal 1₋₉, 1₋₁₁, 1₋₁₃, 1₋₁₅, the fourth multiplexer 21e₋₂ also selects an i^{th} output terminal 1₋₁₀, 1₋₁₂, 1₋₁₄, 1₋₁₆.

As described above, to ahead the four output terminals 1₋₉, 1₋₁₁, 1₋₁₃, 1₋₁₅, the protection diodes of the semiconductor LSI (not shown) are connected. Accordingly, when a constant current is supplied from the constant current circuit 3 to the semiconductor LSI through the input terminal 2, the fifth multiplexer 22, the third relay switch 23o₋₃ and the second multiplexer 21o₋₂. then, by measuring the potential appearing at the output terminal 2, the open/short test with respect to the ninth, eleventh, thirteenth and fifteenth wires of the semiconductor LSI can be sequentially conducted using the protection diodes. That is, when the measured potential at the input terminal 2 is a potential following the diode characteristics, it can be judged to be normal, and when the potential is a clamp potential, it can be judged to be open, and when 0 V, to be short.

After the second multiplexer 21o₋₂ selects all the output terminals 1₋₉, 1₋₁₁, 1₋₁₃, 1₋₁₅, the third relay switch 23o₋₃, the seventh relay switch 23e₋₃ and the eighth relay switch 23₋₄ are switched to be off, and the second multiplexer 21o₋₂ and the fourth multiplexer 21e₋₂ are switched to be off and the first multiplexer 21o₋₁ and the third multiplexer 21e₋₁ are switched to be on. At this time, before the third relay switch 23o₋₃, the seventh relay switch 23e₋₃ and the eighth relay switch 23e₋₄ are turned off, the first relay switch 23ₒ₋₁, the second relay switch 23o₋₂ and the fifth relay switch 23e₋₁ are turned on. Accordingly, the latter half of an on period of the third relay switch 23o₋₃ and the first half of an on period of the fifth relay switch 23e₋₁ are overlapped with each other. Further, the latter half of an on period of the seventh relay switch 23e₋₃ and the first half of an on period of the first relay switch 23o₋₁ are overlapped with each other. Moreover, the latter half of an on period of the eighth relay switch 22e₋₄ and the first half of an on period of the second relay switch 23o₋₂ are overlapped with each other.

The third multiplexer 21e₋₁ becomes in an on state in the latter half of an on period of the fifth relay switch 23e₋₁ (at the time approximately when an on state of the fifth relay switch 23e₋₁ is established). Further, the first multiplexer 21o₋₁ becomes in an on state in the latter half of an on period of the first relay switch 23o₋₁ and the second relay switch 23o₋₂ (at the time approximately when an on state of the first relay switch 23o₋₁ and the second relay switch 23o₋₂ is established). Therefore, after completion of operation of the second multiplexer 21o₋₂ and the fourth multiplexer 21e₋₂, without waiting for the first relay switch 23o₋₁, the second relay switch 23o₋₂ and the fifth relay switch 23e₋₁ to establish their on state, it is allowed to immediately switch to the first multiplexer 21o₋₁ and the third multiplexer 21e₋₁ to operate.

When an on state of the first relay switch 23o₋₁, the second relay switch 23o₋₂ and the fifth relay switch 23e₋₁ is established, a second, fourth, sixth and eighth wires of the semiconductor LSI are connected to the second output terminal CH2 of the fifth multiplexer 22 in the second layer through the third multiplexer 21e₋₁ in the first layer, and a first, third, fifth and seventh wires are connected to ground through the first multiplexer 21e₋₁, the first relay switch 23o₋₁ and the second relay switch 23o₋₂.

At this time, the fifth multiplexer 22 is in operation and switched to select the second input terminal CH2. In addition, the fifth multiplexer 22 can also switch in a high speed from selection of the third input terminal CH3 to selection of the second input terminal CH2.

Accordingly, a state is achieved equivalent to such that only a second, fourth, sixth and eighth wires connected to a second, fourth, sixth and eighth output terminals that the semiconductor LSI to be tested has are connected to the constant current circuit 3 through the two multiplexers 21e₋₁, 22, and the first, third, fifth and seventh wires adjacent to them are connected to ground. At this time, a signal with a constant current provided by the constant current circuit 3 is output sequentially from the output terminals 1₋₂, 1₋₄, 1₋₆, 1₋₈ of the third multiplexer 21e₋₁ through the fifth multiplexer 22 and the fifth relay switch 23e₋₁.

The third multiplexer 21e₋₁ brought into operation under these conditions sequentially switches and outputs the signal provided from the constant current circuit 3 through the fifth multiplexer 22 and the fifth relay switch 23e₋₁, to the four output terminals 1₋₂, 1₋₄, 1₋₆, 1₋₈.

Further, the first multiplexer 21o₋₁ brought into operation at the same time as the third multiplexer 21e₋₁ sequentially switches and selects the four output terminals 1₋₁, 1₋₃, 1₋₅, 1₋₇. Accordingly, the first, third, fifth and seventh wires of the semiconductor LSI connected to the four output terminals 1₋₁, 1₋₃, 1₋₅, 1₋₇ are sequentially connected to ground through the first relay switch 23o₋₁ and the second relay switch 23o₋₂. Here, similarly to the first embodiment, when the third multiplexer 21e₋₁ selects an i^{th} (i = 1, 2, 3, 4) output terminal 1₋₂, 1₋₄, 1₋₆, 1_{-8,} the first multiplexer 21o-₁ selects a (i + 1) ^{th} output terminal 1₋₃, 1₋₅, 1₋₇, 1₋₁. (However, when i = 4, there is not the fifth, and so, the first input terminal 1₋₁ is used).

As described above, to ahead the four output terminals 1₋₂, 1₋₄, 1₋₆, 1₋₈, the protection diodes of the semiconductor LSI (not shown) are connected. Accordingly, when a constant current is supplied from the constant current circuit 3 to the semiconductor LSI through the input terminal 2, the fifth multiplexer 22, the fifth relay switch 23e₋₁ and the third multiplexer 21e₋₁, then, by measuring the potential appearing at the input terminal 2, the open/short test with respect to the second, fourth, sixth and eighth wires of the semiconductor LSI can be sequentially conducted using the protection diodes. That is, when the measured potential at the input terminal 2 is a potential following the diode characteristics, it can be judged to be normal, and when the potential is a clamp potential, it can be judged to be open, and when 0 V, to be short.

After the third multiplexer 21e₋₃ selects all the output terminals 1₋₂, 1₋₄, 1₋₆, 1₋₈, the first relay switch 23o₋₁, the second relay switch 23o₋₂ and the fifth relay switch 23e₋₁ are switched to be off, and the first multiplexer 21o₋₁ and the third multiplexer 21e₋₁ are switched to be off and the second multiplexer 21o₋₂ and the fourth multiplexer 21e₋₂ are switched to be on. At this time, before the first relay switch 23o₋₁, the second relay switch 23o₋₂ and the fifth relay switch 23e₋₁ are turned off, the third relay switch 23o₋₃, the fourth relay switch 23o₋₄ and the seventh relay switch 23e₋₃ are turned on. Accordingly, the latter half of an on period of the first relay switch 23o₋₁ and the first half of that of the third relay switch 23o₋₃ overlap with each other. Further, the latter half of an on period of the second relay switch 23o₋₂ and the first half of that of the fourth relay switch 23o₋₄ overlap with each other. Moreover, the latter half of an on period of the fifth relay switch 23e₋₁ and the first half of that of the seventh relay switch 23e₋₃ overlap with each other.

The fourth multiplexer 21e₋₂ becomes in an on state in the latter half of an on state of the seventh relay switch 23e₋₃ (at the time approximately when an on state of the seventh relay switch 23e₋₃ is established). Further, the second multiplexer 21o₋₂ becomes in an on state in the latter half of an on state of the third relay switch 23o₋₃ and the fourth relay switch 23o₋₄ (at the time approximately when an on state of the third relay switch 23o₋₃ and the fourth relay switch 23o₋₄ is established). Therefore, after completion of operation of the first multiplexer 21o₋₁ and the third multiplexer 21e₋₁, without waiting for the third relay switch 23o₋₃, the fourth relay switch 23o₋₄ and the seventh relay switch 23e₋₃ to achieve their on state, it is allowed to immediately switch to the second multiplexer 21o₋₂ and the fourth multiplexer 21e₋₂ to operate.

When an on state of the third relay switch 23o₋₃, the fourth relay switch 23o₋₄ and the seventh relay switch 23e₋₃ is established, a tenth, twelfth, fourteenth and sixteenth wires of the semiconductor LSI are connected to the fourth output terminal CH4 of the fifth multiplexer 22 in the second layer through the fourth multiplexer 21e₋₂ in the first layer, and a ninth, eleventh, thirteenth and fifteenth wires are connected to ground through the second multiplexer 21o₋₂, the third relay switch 23o₋₃ and the fourth relay switch 23o₋₄.

At this time, the fifth multiplexer 22 is in operation and switched to select the fourth input terminal CH4. In addition, the fifth multiplexer 22 can also switch in a high speed from selection of the second input terminal CH2 to selection of the fourth input terminal CH4.

Accordingly, a state is achieved equivalent to such that only the tenth, twelfth, fourteenth and sixteenth wires connected to the tenth, twelfth, fourteenth and sixteenth output terminals that the semiconductor LSI to be tested has are connected to the constant current circuit 3 through the two multiplexers 21ₑ₋₂, 22, and the ninth, eleventh, thirteenth and fifteenth wires adjacent to them are connected to ground. At this time, a signal with a constant current provided by the constant current circuit 3 is sequentially output from the output terminals 1₋₁₀, 1₋₁₂ 1₋₁₄, 1₋₁₆ of the fourth multiplexer 21e₋₂ through the fifth multiplexer 22 and the seventh relay switch 23e₋₃.

The fourth multiplexer 21e₋₂ brought into operation under these conditions sequentially switches and outputs the signal provided from the constant current circuit 3 through the fifth multiplexer 22 and the seventh relay switch 23ₑ₋₃, to the four output terminals 1₋₁₀, 1₋₁₂, 1₋₁₄, 1₋₁₆.

Further, the second multiplexer 21o₋₂ brought into operation at the same time as the fourth multiplexer 21e₋₂ switches and selects the four output terminals 1₋₉, 1₋₁₁, 1₋₁₃, 1₋₁₅. Accordingly, the ninth, eleventh, thirteenth and fifteenth wires of the semiconductor LSI connected to the four output terminals 1₋₉, 1₋₁₁, 1₋₁₃, 1₋₁₅ are sequentially connected to ground through the third relay switch 23o₋₃ and the fourth relay switch 23o₋₄. Here, when the fourth multiplexer 21e₋₂ selects an i^{th} (i = 1, 2, 3, 4) output terminal 1-₁₀, 1-₁₂, 1₋₁₄, 1₋₁₆, the second multiplexer 21o₋₂ selects a (i + 1)^{th} output terminal 1₋₁₁, 1₋₁₃, 1₋₁₅, 1₋₉. (However, when i = 4, there is not the fifth, and so, the first output terminal 1₋₉ is used).

As described above, to ahead the four output terminals 1₋₁₀, 1₋₁₂, 1₋₁₄, 1₋₁₆, the protection diodes of the semiconductor LSI (not shown) are connected. Accordingly, when a constant current is supplied from the constant current circuit 3 to the semiconductor LSI through the input terminal 2, the fifth multiplexer 22, the seventh relay switch 23e₋₃ and the fourth multiplexer 21e₋₂, then, by measuring the potential appearing at the input terminal 2, the open/short test with respect to the tenth, twelfth, fourteenth and sixteenth wires of the semiconductor LSI can be sequentially conducted using the protection diodes. That is, when the measured potential at the input terminal 2 is a potential following the diode characteristics, it can be judged to be normal, and when the potential is a clamp potential, it can be judged to be open, and when 0 V, to be short.

While the first and second multiplexers 21o₋₁, 21o₋₂ in the odd block "Odd" and the third and fourth multiplexers 21e₋₁, 21e₋₂ in the even block "Even" are seamlessly operating in a way described above, the fifth multiplexer 22 is always in operation and sequentially selects the first to fourth output terminals CH1 to CH4.

As described above in detail, according to the second embodiment, while the wires of the semiconductor LSI are sequentially selected in a high speed using the multiplexers 21o₋₁, 21o₋₂, 21e₋₁, 21e₋₂ capable of operating in a higher speed as compared to the relay switch, and another wires adjacent to the selected wires are switched to be connected to ground through the relay switches 23o₋₂, 23o₋₄, 23e₋₂, 23e₋₄, then, by measuring the potential appearing at the input terminal 2, the open/short test using the protection diodes can be conducted in an extremely high speed. Further, because the input terminal 2 is limited to one input terminal using a plurality of multiplexers, only one constant current circuit 3 connected to it is necessary, which can reduce the circuit scale of the connected state inspecting instrument.

Further, in the second embodiment, except the relay switch connected to the multiplexer during selection of a signal in the first layer and the relay switch which is turned on for grounding, other relay switches are turned off, whereby, the resistance component (R) and the capacitance component (C) of the multiplexer in the first layer where the relay switch is turned off can be separated off from the tree structure. Accordingly, the value of the time constant (CR) which affects the operating speed of the multiplexer circuit can be not increased. In addition, generally, because the relay switch has a considerably smaller resistance as compared to the multiplexer, even if it is connected to the multiplexer in a cascade arrangement, a value of a series resistance can be decreased, as compared to the case where the multiplexers are connected to each other in a cascade arrangement, and as the result, the time constant (CR) can be decreased.

Further, in the second embodiment, inputs of the four multiplexers 21o₋₁, 21o₋₂, 21e₋₁, 21e₋₂ are respectively connected to the four output terminals CH1 to CH4 of the fifth multiplexer 22, and a plurality of multiplexers are not connected in parallel to one output terminal. That is, to one output terminal of the fifth multiplexer 22 in the second layer, only two relay switches are connected in parallel, and to only one of them, only one multiplexer in the first layer is connected in a cascade arrangement. Therefore, the number of multiplexers and relay switches connected in parallel to one signal line is reduced, whereby the value itself of the capacitance component (C) in individual multiplexers or individual relay switches cannot be enlarged.

As described above, according to the second embodiment, many multiplexers and relay switches are not interconnected concurrently, whereby, many resistance components (R) or capacitance components (C) cannot be connected in a cascade arrangement, and at the same time, the value itself of the resistance component (R) or the capacitance component (C) that individual multiplexers or individual relay switches have can be reduced. Therefore, the value of the total time constant (CR) can be decreased and a disadvantage can be prevented that an increase of the time constant (CR) lowers an operating speed of the entire multiplexer circuit.

Further, according to the second embodiment, on periods of three groups of relay switches from among eight relay switches 23o₋₁ to 23o₋₄, 23e₋₁ to 23e₋₄ are overlapped with each other. Therefore, when the multiplexer in the first layer used for selection of wires is switched to a next one, and a wire adjacent to the selected wire is connected to ground, it is quite unnecessary to wait a long time until the relay switch connected to a new multiplexer after switching is turned from off to on. That is, without waiting a long time until an on state of the relay switch is established, a plurality of multiplexers 21o₋₁, 21o₋₂, 21e₋₁, 21e₋₂ in the first layer can be sequentially switched in a seamless manner to be operated. Accordingly, the open/short test using the protection diodes can be conducted in an extremely high speed.

In addition, in the second embodiment described above, the example, in which, first, the first and second multiplexers 21o₋₁, 21o₋₂ in the odd block "Odd" are sequentially selected, and subsequently the third and fourth multiplexers 21e₋₁, 21e₋₂ in the even block "Even" sequentially selected, has been described, but the present invention is not limited to this example. For example, the first and second multiplexers 21o₋₁, 21o₋₂ in the odd block "Odd", and the third and fourth multiplexers 21e₋₁, 21e₋₂ in the even block "Even" may be alternately selected.

Moreover, in the second embodiment described above, when the first and third relay switches 23o₋₁, 23o₋₃ in the odd block "Odd" select any of the first and second multiplexers 21o₋₁, 21o₋₂, the fifth to eighth relay switches 23e₋₁ to 23e₋₄ in the even block "Even" all may be turned on to connect the even block "Even" all to ground. When the fifth and seventh relay switches 23e₋₁, 23e₋₃ in the even block "Even" select any of the third and fourth multiplexers 21e₋₁, 21e₋₂, the first to fourth relay switches 23o₋₁ to 23o₋₄ in the odd block "Odd" all may be turned on to connect the odd block "Odd" all to ground.

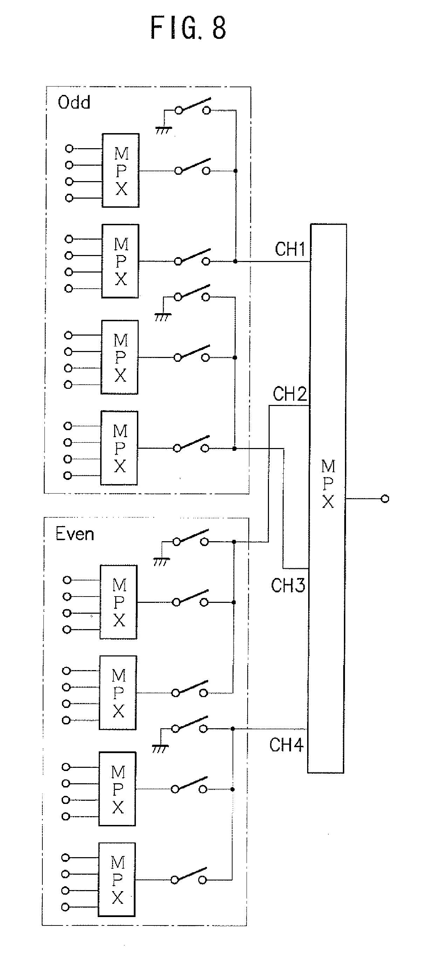

Further, in the second embodiment described above, the example as configured in a manner that only one multiplexer is connected to one output terminal of the fifth multiplexer 22 in the second layer (for example, only the first multiplexer 21o₋₁ is connected to the first output terminal CHl) has been described. As described above, the smaller number of multiplexers connected in parallel may advantageously not increase the value itself of the capacitance component (C) that the multiplexer itself has. But the number of connection does not necessarily have to be one, and as shown in Figure 8, a plurality of multiplexers may be connected in parallel to one output terminal. In this case, the relay switches are respectively provided between the one output terminal and the plurality of multiplexers, and in parallel to these relay switches, one relay switch is provided for grounding. Further, in the case as configured in such way, after the multiplexer connected to some output terminal is selected, the multiplexer connected to another output terminal may be preferably selected. By alternately selecting the multiplexers connected to different output terminals, even if there are two relay switches of which on states concurrently overlap with each other, one of them is not selected by the fifth multiplexer 22 and it is separated off from the tree structure, which is more preferable for decreasing the time constant (CR).

Further, in the first embodiment described above, the example, in which each of the multiplexers 11o, 11e in the first layer includes the four output terminals and the multiplexer 12 in the second layer includes the two output terminals, has been described, but the number of input terminals shown here is only an example and not limited to this. Further, in the second embodiment described above, the example, in which each of the multiplexers 21o₋₁, 21o₋₂, 21e₋₁, 21e₋₂ in the first layer includes the four output terminals and the multiplexer 22 in the second layer includes the four output terminals, has been described, but the number of input terminals shown here is only an example and not limited to this.

Further, in the first embodiment described above, the example in which the first layer includes the two multiplexers 11o, 11e and in the second embodiment described above, the example in which the first layer includes the four multiplexers 21o₋₁, 21o₋₂, 21e₋₁, 21e₋₂ have been described, but the numbers of multiplexers shown here are only an example and not limited to these.

Moreover, in the first and second embodiments described above, the configuration in a tree connection including a two-layer structure composed of the first and second layers has been described, but the number of layers shown here is only an example and not limited to this.

Further, in the first and second embodiments described above, the example in which the input terminal 2 is finally reduced to one terminal has been described, but the present invention is not limited to this. The number of input terminals may be multiple. The smaller number of input terminals brings advantages that the number of the constant current circuits 3 connected to the input terminals may be decreased and the circuit scale may be more reduced, but it is not necessarily required to reduce the number of input terminals to one. For example, when an ultra-many-pin structure LSI having more than a few thousand wires to be selected is an object under test, only reducing the input terminals to several has an extremely large effect to cut down the circuit scale. In addition to it, by conducting the open/short test in parallel using several constant current circuits 3, enhancement of a processing speed can be also achieved.

Further, in the first embodiment described above, the first relay switch 13o₋₁ and the third relay switch 13e₋₁ are not provided, and these parts are shunted, and then only the second relay switch 13o₋₂ and the fourth relay switch 13e₋₂ may switch connection of the output terminals of the first and second multiplexers 11₀, 11e to a ground terminal.

Similarly, in the second embodiment described above, the first relay switch 23o₋₁, the third relay switch 23o₋₃, the fifth relay switch 23e₋₁ and the seventh relay switch 23e₋₃ are not provided, and these parts are shunted, and then, only the second relay switch 23o₋₂, the fourth relay switch 23o₋₄, the sixth relay switch 23e₋₂ and the eighth relay switch 23e₋₄ may switch connection of the output terminals of the first to fourth multiplexers 21o-₁, 21o₋₂, 21e₋₁ 21e₋₂, to a ground terminal.

However, as shown in the first and second embodiments described above, if, between the multiplexers in the first layer and the multiplexers in the second layer, the relay switch is provided, the multiplexers in the first layer can be separated off from the tree structure by turning the relay switch off when not selecting a signal and required to operate, which is more preferable for decreasing the time constant (CR).

Further, in the first and second embodiments described above, the example in which the open/short test is conducted by connecting the connected state inspecting instrument of the embodiments to the output terminals of the semiconductor LSI has been described, but, similarly, the open/short test can be also conducted by connecting the connected state inspecting instrument of the embodiments to input terminals of the semiconductor LSI.

In addition, either of the first and second embodiments described above only shows an example of embodiment for implementing the present invention, so that it should not be construed that these limit the technical scope of the present invention. That is, the present invention may be made in various forms without departing the sprit or main features of the present invention.

### [Industrial Applicability]

The present invention is useful for an instrument which inspects for an open fault (open circuit) of wires of a semiconductor and a short fault (short circuit) between the wires at the same time. It may be thought that operation technology of the wiring connected state inspecting instrument according to the present invention is applied to, for example, a test system which inspects electrical characteristics of a semiconductor LSI having ultra-many-pin outputs.

## Claims

1. A wiring connected state inspecting instrument, comprising:
an odd multiplexer for sequentially switching a plurality of terminals connected to odd-numbered wires to select one-by-one,
an even multiplexer for sequentially switching a plurality of terminals connected to even-numbered wires to select one-by-one,
a multiplexer in a higher-level layer for sequentially switching a plurality of terminals connected to the odd multiplexer and the even multiplexer to select one-by-one,
an odd relay switch connected between the odd multiplexer and the multiplexer in the higher-level layer, for switching connection of the odd multiplexer to a ground terminal, and
an even relay switch connected between the even multiplexer and the multiplexer in the higher-level layer, for switching connection of the even multiplexer to a ground terminal,
wherein when one of the odd relay switch and the even relay switch does not select connection to the ground terminal, the other selects connection to the ground terminal.

2. The wiring connected state inspecting instrument according to claim 1, comprising:
a plurality of groups of the odd multiplexer and the even multiplexer, and
a plurality of groups of the odd relay switch and the even relay switch,
wherein when any one of the odd relay switches does not select connection to the ground terminal, at least any one of the even relay switches corresponding to the
